**Europäisches Patentamt**

(19) **European Patent Office**

**Office européen des brevets**

(11) Numéro de publication: **0 011 737**
**B1**

(12) **FASCICULE DE BREVET EUROPEEN**

(45) Date de publication du fascicule du brevet: **23.03.83**

(51) Int. Cl.³: **H 01 L 27/02**

(21) Numéro de dépôt: **79104339.1**

(22) Date de dépôt: **06.11.79**

(54) Structure de circuits intégrés semi-conducteurs et procédé pour l'obtention de cette structure.

(30) Priorité: **30.11.78 FR 7834433**

(43) Date de publication de la demande:
**11.06.80 Bulletin 80/12**

(45) Mention de la délivrance du brevet:
**23.03.83 Bulletin 83/12**

(84) Etats contractants désignés:
**DE FR GB**

(56) Documents cités:
**FR - A - 2 276 693**
**FR - A - 2 315 804**
**FR - A - 2 365 883**

**PATENT ABSTRACTS OF JAPAN, vol. 1, no. 19, 24 mars 1977; page 612E76**

(73) Titulaire: **International Business Machines Corporation**
**Armonk, N.Y. 10504 (US)**

(72) Inventeur: **Capuron, Jean-Pierre**
**No. 1 Rue Gabrielle d'Estrées**
**F-91830 Coudray-Montceaux (FR)**

(74) Mandataire: **Lattard, Nicole**
**COMPAGNIE IBM FRANCE Département de Propriété Industrielle**
**F-06610 La Gaude (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

Structure de circuits intégrés semi-conducteurs et procédé pour l'obtention de cette structure

Domaine technique

La présente invention concerne une structure de circuits intégrés semi-conducteurs et elle concerne plus particulièrement une structure de ces circuits sur une microplaquette facilitant la conception d'ensemble logique ainsi qu'un procédé d'obtention de cette structure.

Actuellement pour réaliser un ensemble logique, le technicien dispose de deux techniques: soit il utilise une tranche maîtresse (technique de réalisation par tranche maîtresse) et il la personnalise, soit il réalise entièrement l'ensemble dans une microplaquette (technique de réalisation à la demande).

Une tranche maîtresse est une microplaquette qui comporte un certain nombre d'éléments de base à savoir différents types de portes logiques ET, OU, OU Exclusif, appelés cellules élémentaires, et la personnalisation implique une étape de métallisation au cours de laquelle certaines cellules sont reliées entre elles pour réaliser l'ensemble logique désiré. Au contraire lorsque le technicien conçoit l'ensemble dans la microplaquette il part d'une tranche de silicium dans laquelle tout l'ensemble est créé à partir de composants élémentaires.

Ces deux techniques ont chacune leurs avantages. La technique de réalisation par tranche maîtresse fait gagner du temps, tant au moment de l'étude sur le papier qu'à celui de la fabrication, mais du fait que le câblage entre les éléments existants, même s'il est fait par des procédés automatiques prend de la place, et que tous les éléments ne sont pas utilisés, la densité d'intégration n'est pas très élevée.

Par contre la technique de réalisation à la demande permet d'atteindre des densités d'intégration optimum puisque les composants nécessaires, transistors, résistances, etc. sont utilisés et en outre sont disposés dans la microplaquette pour que le câblage prenne le moins de place possible. De plus le technicien n'a pas à utiliser des circuits donnés réalisant une certaine fonction mais il peut utiliser des circuits particuliers mieux adaptés.

Technique antérieure

Pour améliorer la technique de réalisation par tranche, il a été proposé dans la demande de brevet européen No. 781006549 déposée le 16 août 1978 sous le titre: "Integrierte Halbleiterschaltung" d'améliorer la structure d'une tranche maîtresse en prévoyant des cellules actives (c'est-à-dire ayant une certaine fonction) et des cellules de câblage qui ne servent qu'au câblage entre des cellules actives. En effet ou s'est aperçu que lors du câblage d'une microplaquette du type tranche maîtresse dans laquelle, ainsi qu'il est classique, les cellules sont disposées en rangées et colonnes, la densité de câblage est supérieure dans les zones centrales à celle dans la périphérie de la microplaquette. Donc des cellules actives en certains endroits de la microplaquette sont supprimées et remplacées par des cellules de câblage, ce qui donne des possibilités de câblage accrues là où la nécessité s'en fait ressentir, sans pour cela étendre ces possibilités à toute la microplaquette, ce qui aurait pour effet de réduire de façon très importante la densité d'integration.

Cette solution relève entièrement de la technique de réalisation par tranche maîtresse et en conséquence en présente tous les avantages notamment au moment de la conception d'un ensemble à partir des cellules de base, cependant elle ne permet pas d'augmenter la densité d'integration au-delà d'une certaine limite pour se rapprocher de celle qui peut être atteinte par la technique de réalisation à la demande.

Exposé de l'invention

Par conséquent, le principal objet de la présente invention est de fournir une structure de circuits intégrés pour la réalisation d'ensembles logiques sur une microplaquette semi-conductrice qui offre à la fois les avantages des densités importantes de la technique de réalisation à la demande et les avantages de facilité de conception de la technique de réalisation par tranche maîtresse.

Un autre objet de la présente invention est de fournir au technicien devant réaliser un ensemble logique, traitant des mots de n bits un procédé d'organisation de l'ensemble pour obtenir un arrangement des circuits dans lequel le câblage est réduit au minimum.

Actuellement les progrés constants de la technologie dans le domaine des semi-conducteurs rendent possible l'intégration de 3000 à 10 000 circuits sur une même microplaquette. En conséquence, pour bénéficier des avantages de la technologie il faut réduire au minimum les longueurs de tous les câbles aussi bien constitués par les interconnexions entre composants que les interconnexions entre cellules.

Conformément à la présente invention, tout l'ensemble logique du type micro-calculateur ou autre est réalisé à partir de cellules complexes de largeur normalisée. On appelle cellule complexe une cellule qui réalise une certaine fonction donnée à savoir une bascule, un circuit de multiplexage, un compteur ou autre. Cette bascule est optimisée, c'est-à-dire qu'elle n'est pas réalisée à partir de cellules élémentaires portes ET, OU, OU Exclusif mais de composants tels que transistors, résistances, etc., dont ou peut optimiser la mise en place et les interconnexions.

Tous les différents types de cellules complexes qui sont susceptibles d'entrer dans la conception d'ensembles logiques sont réalisés avec la même largeur (dimension X), la longueur (dimension Y) pouvant varier suivant le type de cellule complexe.

Un ensemble logique tel qu'un micro-calculateur traitant des mots de n bits est constitué d'unités fonctionnelles généralement à n étages, à savoir registres, unité logique et arithmétique, circuit de sélection de registre, etc. Pour réaliser un tel ensemble, les cellules complexes adéquates, par exemple des bascules dans le cas du registre, sont disposées côte-à-côte parallèlement à l'axe des abscisses x, et sont répétées autant de fois qu'il est nécessaire, généralement n fois pour réaliser l'unité fonctionnelle désirée.

Les unités fonctionnelles ainsi réalisées sont ensuite disposées les unes au-dessous des autres de façon que les cellules complexes traitant des bits de même poids se trouvent les unes au-dessous des autres dans une même colonne parallèle à l'axe des ordonnées y.

Toute la mise en place des cellules complexes se fait donc sur une grille en utilisant la technique bien connue de conception automatique de circuits par ordinateur.

Le câblage des différents éléments dans une unité fonctionnelle se fait au premier niveau de métallurgie. Les interconnexions entre les unités fonctionnelles se font à un second niveau de métallurgie en passant au-dessus des cellules complexes, le câblage se fait par colonne, le câblage d'une colonne pouvant être ensuite transposé dans les autres colonnes pour tous les cas où il existe une répétitivité. Un certain espacement entre les unités fonctionnelle est réservé dans le cas où des déroutements de fils sont nécessaires.

Etant donné que la réalisation physique d'une unité fonctionnelle à partir de cellules complexes, même dans l'hypothèse d'une optimisation soignée fait apparaître des zones inoccupées dans les cellules elles-mêmes et entre les cellules, on peut orienter l'optimisation des composants et de leurs interconnexions de telle sorte que des zones inoccupées soient utilisées pour fournir plusieurs points d'accès pour une seule et même entrée ou sortie.

Le procédé qui permet l'obtention de la structure de circuits conforme à l'invention consiste donc à créer un catalogue de cellules complexes de dimension standard X ayant plusieurs points d'accès aux entrées et sorties, à décomposer l'ensemble logique que l'on veut réaliser pour traiter des mots de n bits, en unités fonctionnelles de même longueur égale à un multiple de X, à disposer ces unités fonctionnelles les unes endessous des autres pour fournir des colonnes de cellules traitant des bits de même poids, à câbler les cellules d'une colonne entre elles, et à transposer les parties de ce câblage qui se répètent dans les différentes colonnes aux cellules des autres colonnes.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des dessins

La figure 1 représente le schéma d'un circuit pouvant être utilisé comme cellule complexe.

La figure 2 représente au niveau du silicium les éléments, transistors, résistances, diodes à barrière de Schottky, intégrés pour réaliser la cellule complexe de la figure 1.

La figure 3 représente les connexions nécessaires au premier et second niveaux de métallique pour réaliser le câblage des éléments de la figure 2.

Les figures 4A et 4B représentant une vue en coupe et de dessus d'un transistor classique pour faciliter la compréhension de la figure 2.

La figure 5 représente très schématiquement la structure d'un ensemble logique obtenue conformément au procédé de la présente invention.

La figure 6 représente une partie des connexions d'une microplaquette obtenue conformément au procédé de l'invention.

Exposé de l'invention

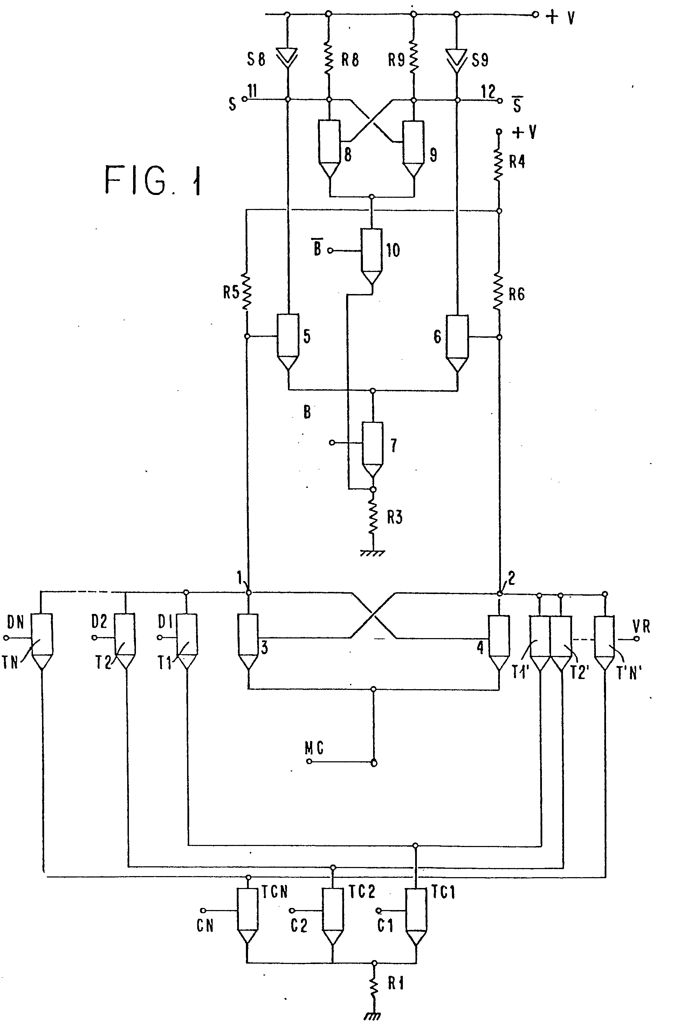

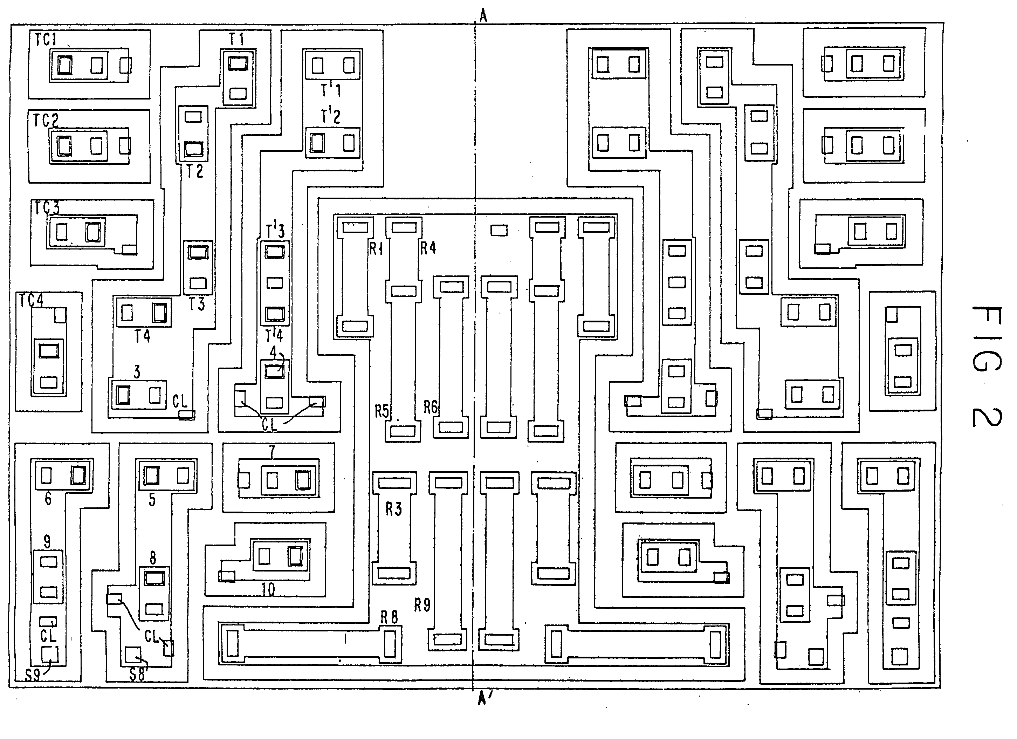

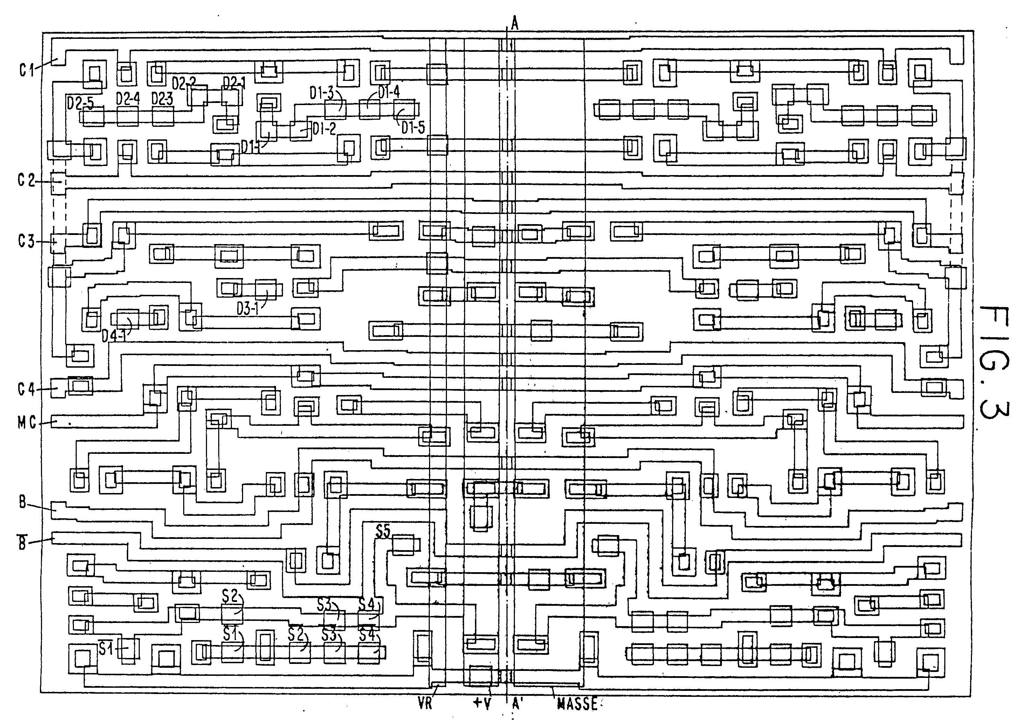

La figure 1 représente une bascule qui peut être utilisée comme cellule complexe pour la réalisation d'un registre constituant une unité fonctionnelle destinée à un ensemble logique tel qu'un micro-calculateur. Cette bascule n'est montrée qu'à titre d'exemple et peut bien entendu être réalisée de différentes façons conformément à la technique de réalisation à la demande.

La bascule de la figure 1 est du type ECL (logique à émetteurs couplés). Bien que ce type de logique ait été utilisé dans un mode de réalisation préféré il est bien évident que d'autres types de logiques peuvent être choisis par exemple TTL ou autre.

La bascule comprend une première série de transistors T1 à TN sur les bases desquelles sont appliquées les données d'entrée D1 à DN respectivement. Les transistors T1 à TN sont montés en commutateur de courant avec les transistors T1' à TN', c'est-à-dire qu'ils ont leurs émetteurs reliés deux à deux, les émetteurs de T1 et T1' sont reliés ainsi que ceux de T2 et T2' et de TN et TN'. Les bases des transistors T1' à TN' sont connectées à une tension de référence VR.

Les émetteurs communs de chaque paire de transistors T1, T1' à TN, TN' sont reliés aux collecteurs des transistors de commutation TC1 à TCN respectivement. Ces transistors de commutation ont leurs émetteurs reliés ensemble, le point commun étant connecté par une résistance R1 à la masse. L'état, conducteur ou non des transistors TC1 à TCN est commandé par des signaux C1 à CN appliqués sur leurs bases.

Les collecteurs des transistors T1 à TN sont reliés tous ensemble à l'entrée 1 d'une bascule maîtresse et les collecteurs des transistors T1' à TN' sont reliés tous ensemble à l'entrée 2 de la bascule. La bascule maîtresse comprend deux transistors 3 et 4 couplés en croix, c'est-à-dire que la base de l'un est couplée au collecteur de l'autre. Les émetteurs des transistors 3 et 4 sont reliés ensemble et un signal de commande MC est appliqué aux émetteurs des transistors 3 et 4.

Les bornes 1 et 2 de la bascule maîtresse sont reliées à un étage de commande comprenant trois transistors 5, 6 et 7. Les bases des transistors 5 et 6 sont reliées aux bornes 1 et 2 respectivement.

Les émetteurs des transistors 5 et 6 sont connectés en commun au collecteur du transistor 7. La base du transistor 7 reçoit un signal d'horloge B et son émetteur est relié à la masse par une résistance R3. Les bases des transistors 5 et 6 sont d'autre part polarisées par un réseau de résistances R4, R5 et R6 et une tension d'alimentation V. La base du transistor 5 est connectée à une borne de la résistance R5 et la base du transistor 6 est connectée à une borne de la résistance R6. Les autres bornes des résistances R5 et R6 sont connectées ensemble à une borne de la résistance R4 dont l'autre borne est connectée à la tension V.

La bascule esclave est aussi constituée de deux transistors couplés en croix 8 et 9. Les émetteurs des transistors 8 et 9 sont reliés ensemble au collecteur du transistor 10 dont la base reçoit l'inverse du signal d'horloge B, soit $\overline{B}$. L'émetteur du transistor 10 est connecté à la masse par la résistance R3. Le collecteur du transistor 8 au noeud 11 est connecté d'une part au collecteur du transistor 5 et d'autre part à la tension V par une résistance R8 montée en parallèle avec une diode de Schottky S8 de limitation de niveau. De même le collecteur du transistor 9 au noeud 12 est connecté d'une part au collecteur du transistor 6 et d'autre part à la tension V par une résistance R9 montée en parallèle sur une diode de Schottky S9.

Ce schéma est bien connu, on fonctionnement sera rappelé brièvement.

On va pour cela supposer que l'on veut entrer un bit de données sur l'entrée D2. Le transistor TC2 est rendu conducteur par un signal de niveau haut sur la borne C2. En conséquence, si le bit de données est au niveau 1, le transistor T2 est conducteur et T2' est bloqué. Le niveau au point 1 est bas et celui au point 2 est haut si bien que le transistor 3 est conducteur et le transistor 4 est bloqué. Les niveaux aux points 1 et 2 sont ensuite transférés à la bascule esclave. Dans un premier temps, le signal d'horloge B étant haut, le transistor 5 est bloqué et le transistor 6 est conducteur. En conséquence le niveau au point 11 est haut et celui au point 12 est bas. Dans un deuxième temps lorsque le signal d'horloge $\overline{B}$ est haut et rend conducteur le transistor 10, le transistor 9 devient conducteur et le transistor 8 est bloqué si bien que le niveau en 11 est haut et celui en 12 est bas. La sortie S du circuit est prise au point 11 et le complément $\overline{S}$ est obtenu au point 12.

Le fonctionnement de la bascule lorsque le bit de données d'entrée est zéro, ne sera pas repris dans le détail car il est évident pour l'homme de l'art.

On va maintenant montrer en se référant aux figures 2 et 3 comment plusieurs cellules complexes du type précédemment décrit peuvent être assemblées pour réaliser une unité fonctionnelle.

La figure 2 représente deux cellules complexes à quatre entrées chacune, (N=4) au niveau du silicium, c'est-à-dire qu'elle montre tous les éléments, transistors, résistances, diodes, intégrées dans le silicium tandis que la figure 3 représente les connexions entre les éléments pour réaliser les deux cellules de l'unité fonctionnelle. Les connexions entre les cellules d'unités fonctionnelles différentes ne sont pas représentées sur cette figure. Les deux figures 2 et 3 sont réalisées à la même échelle, si bien que leur superposition montre comment sont intégrées les deux cellules.

Comme on peut le voir sur les figures 2 et 3 les cellules sont symétriques par rapport à la ligne A—A' et ces deux cellules ont les mêmes dimensions en largeur (dimension X) et en longueur (dimension Y). Conformément à une caractéristique de l'invention, les lignes d'alimentation VR, V et MASSE, sont communes à deux cellules complexes et en conséquence placées autour de l'axe de symétrie parallèlement à cet axe.

Comme on peut le voir sur la figure 2, les transistors qui ont leurs collecteurs reliés en commun par exemple T1 à T4 et 3 ainsi que T1' à T4' et 4 sont situées dans une même poche d'isolation et ne comportent que le nombre de contacts aux collecteurs nécessaires à savoir 1, 2 ou 3 suivant le cas, ces collecteurs sont repérés par la lettre CL.

Les éléments on été placés de façon que les lignes de commande communes à toutes les cellules de l'unité fonctionnelle soient sur une ligne pratiquement horizontale avec le moins de déroutement possible. On peut voir sur la figure 3, les lignes de commande permettant d'appliquer les signaux $\overline{B}$, B, MC, C1 à C4. Ces lignes sont communes pour les deux cellules consécutives de la figure 3 et il est bien entendu qu'elles se prolongent pour les cellules suivantes de l'unité fonctionnelle considérée.

Conformément à une caractéristique de l'invention, il y a plusieurs points par lesquels on peut accéder à une entrée ou à sortie. Par exemple on peut accéder à l'entrée D1 en D1-1 à D1-5, de même on peut accéder à l'entrée D2 en D2-1 à D2-5. De même on peut prendre les sorties vraie et complémentaire S et $\overline{S}$ en S1 à S5 et $\overline{S1}$ à $\overline{S4}$. Cette possibilité évite qu'un trop grand nombre de déroutements soit nécessaire lorsqu'on fait le câblage général des unités fonctionnelles entre elles.

La connexion en pointillés terminée par deux trous de connexion est réalisée au deuxième niveau de métal pour relier tous les émetteurs des transistors T1 à T4.

La réalisation d'un ensemble logique, conformément à la présente invention implique donc la réalisation de toutes les unités fonctionnelles rentrant dans l'ensemble à partir de cellules complexes de mêmes dimensions X, les cellules de deux unités fonctionnelles différentes peuvent avoir des dimensions Y différentes mais il est impératif que les dimensions X soient les mêmes.

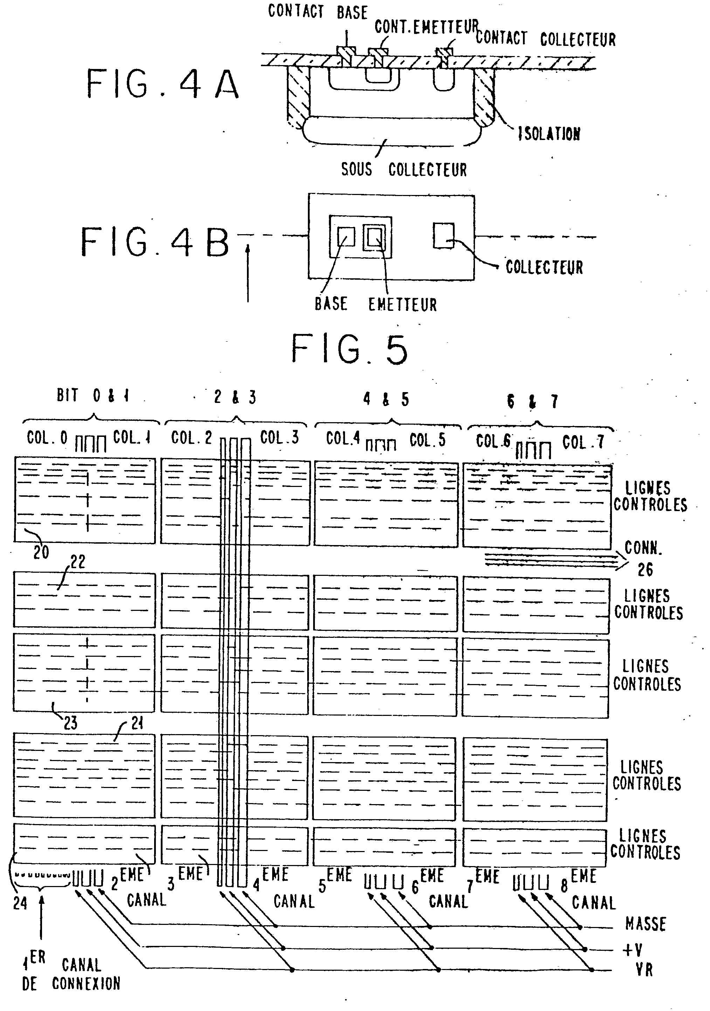

On va montrer en se référant à la figure 5 comment peuvent être disposées plusieurs unités fonctionnelles. Sur cette figure, sont schématisées cinq unités fonctionnelles par exemple des registres 20 et 21 identiques à celui des figures 2 et 3 des circuits de sélection 22, 23 et 24 à trois, cinq et deux voies respectivement. A l'intérieur des unités fonctionnelles les connexions sont faites au premier niveau de métallurgie. Parmi toutes les connexions nécessaires ne sont représentées en pointillés sur la figure 5 que celles correspondant aux lignes de commande horizontales communes aux différentes cellules des unités fonctionnelles.

Les cellules élémentaires de chaque unité sont disposées côte-à-côte, deux cellules consécutives partageant les mêmes lignes d'alimentation VR, V et MASSE situées au second niveau de métal.

Les unités fonctionnelles sont disposées les unes au-dessous des autres. En supposant que l'ensemble traite des mots de 8 bits, les unités fonctionnelles sont disposées de façon que les cellules complexes situées dans une même colonne traitent toutes des bits de même poids, par exemple les troisièmes cellules de toutes les unités fonctionnelles traitent les bits de poids 2 des mots d'entrée. Les connexions entre unités fonctionnelles se font donc dans les canaux verticaux qui correspondent aux poids des bits, ces connexions sont situées au second niveau de métallurgie. Des espaces sont laissés entre les unités fonctionnelles, des connexions au premier niveau de métallurgie peuvent être faites dans ces espaces si la nécessité s'en fait sentir. Trois connexions 26 de ce type sont schématisées entre les unités 20 et 22.

La réalisation d'un ensemble logique conformément au procédé de la présente invention est particulièrement facile lorsqu'on utilise les techniques de conception par ordinateur. Pour cela, toutes les cellules complexes sont mises en mémoire, ainsi que tous les éléments qui sont nécessaires pour la disposition de l'ensemble, à savoir les trous de connexion entre niveaux de métallurgie différents, pour pouvoir passer d'un niveau à l'autre. Le technicien qui doit câbler un ensemble donné, travaille à une terminal équipé d'un écran sur lequel à l'aide d'un crayon lumineux il disposera les cellules complexes et les unités fonctionnelles et fera les liaisons entre elles conformément au schéma donné de l'ensemble. Il est bien entendu que tout ou partie du câblage entre cellules d'une même colonne se répétant d'une colonne à l'autre, il n'est pas nécessaire de reprendre entièrement le câblage pour chaque colonne, ceci pouvant être fait automatiquement.

Du fait de la disposition symétrique des cellules dans deux colonnes consécutives partageant les mêmes lignes d'alimentation, le schéma de câblage obtenu pour une colonne, par exemple la colonne 0 est transposé par symétrie dans la colonne 1, ensuite le schéma de câblage de l'ensemble constitué par ces deux colonnes peut être répété dans les colonnes suivantes. La technique de câblage automatique ne faisant pas partie de la présente invention, elle ne sera pas décrite plus en détail.

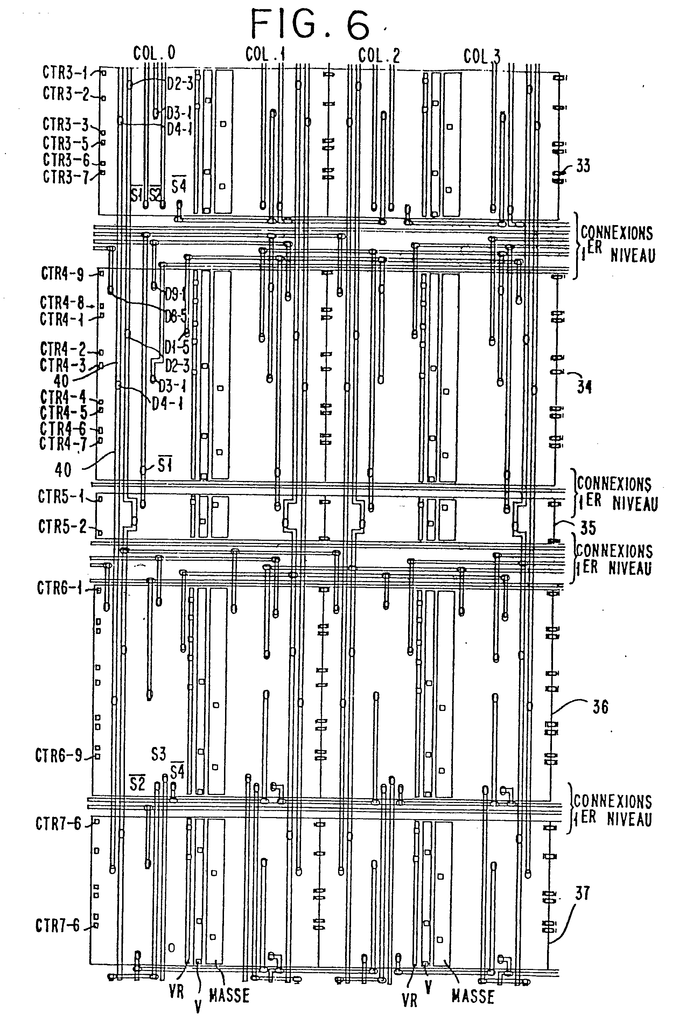

La figure 6 représente schématiquement une partie d'une microplaquette câblée conformément aux principes de la présente invention. Cinq unités fonctionnelles 33 à 37 sont représentées à l'intérieur de chacune des unités, quatre cellules complexes seulement sont représentées, ces cellules déterminant des colonnes, colonnes 0 à 3. La colonne 0 sera réservée au traitement des bits d'ordre 0 des mots d'entrée de l'ensemble logique, la colonne 1 aux bits d'ordre 1 et ainsi de suite.

Sur les côtés des cellules complexes, côté gauche des cellules de la colonne 0 et côté droit des cellules de la colonne 1 par exemple, on peut voir schématisées les extrémités des lignes de commande référencées par l'abréviation CTR, CTR4-1 représentant la ligne de commande 1 de la cellule fonctionnelle 33. Ces lignes de commande correspondent aux lignes C1 à C4, MC, B et B de la figure 3 plus deux lignes de commande supplémentaires, correspondant à deux possibilités supplémentaires d'entrée de données D8 et D9 respectivement.

Les lignes de commande horizontales permettant d'appliquer les signaux de commande aux cellules sont au premier niveau de métallurgie ainsi que toutes les lignes horizontales placées entre les unités fonctionnelles. Le nombre de lignes de commande dépend du type d'unités fonctionnelles.

Les lignes verticales telles que 40 dans différentes colonnes sont mises en place une fois que les cellules complexes et les unités fonctionnelles ont été disposées, elles se trouvent donc au second niveau de métallurgie ainsi que les lignes d'alimentation VR, V et MASSE. Des trous de connexion sont prévus pour passer d'un niveau à l'autre pour assurer la continuité des chemins électriques.

Le câblage des unités fonctionnelles se fait par colonne, chaque colonne correspondant à un bit d'un ordre donné des mots d'entrée. Ce câblage est calqué sur le schéma de l'ensemble logique particulier à réaliser. La figure 6 n'est donnée que pour montrer les connexions obtenues pour un ensemble quelconque. On peut voir que ces connexions comportent peu de déroutement; en effet, grâce aux points d'accès multiples pour une entrée ou une sortie des cellules complexes, lorsqu'on veut connecter la sortie d'une cellule à l'entrée d'une autre cellule, on trouve dans la plupart des cas deux points qui peuvent être reliés sans déroutement. Le technicien assurant la mise en place du câblage choisira les points d'accès qui lui permettent d'éviter les déroutements et ainsi les longueurs des connexions sont réduites au minimum.

Certains points d'accès de la cellule de la colonne 0 de l'unité 34 ont été référencés par les mêmes références que sur la figure 3.

Du fait que chaque colonne correspond à un ordre de bit de mots d'entrée, il est évident que les câblage des différentes colonnes se déduisent en partie des câblages de la colonne 0. Donc en tenant compte de la disposition symétrique des éléments des colonnes 0 et 1, des colonnes 2 et 3, etc., certaines connexions, notamment celles correspondant à l'introduction des bits dans les unités fonctionnelles sont obtenues par transposition des connexions de la colonne 0. Ainsi donc dans la colonne 0, toutes les connexions qui se répétent dans les colonnes suivantes sont mises en place, et elles sont ensuite transposées dans les autres colonnes. Puis les connexions particulières à chaque colonne sont ensuite mises en place, ce sont celles qui correspondent par exemple au câblage d'une colonne à une autre.

La réalisation d'ensembles logiques présentant la structure décrite précédemment en référence aux figures 5 et 6 implique donc, dans une première phase la conception d'un catalogue de cellules complexes telles que représentées sur les figures 2 et 3, des cellules ayant toutes une même dimension X.

La phase de conception d'un ensemble logique traitant des mots de n bits, à partir du catalogue de cellules complexes mis en mémoire comprend les étapes suivantes:

. association de plusieurs cellules pour réaliser les différentes unités fonctionnelles à n étages, entrant dans la composition de l'ensemble,

. disposition des unités fonctionnelles les unes au-dessous des autres, les cellules de chaque unité traitant des bits de même poids se trouvant dans unes même colonne,

. câblage des différentes cellules d'une même colonne,

. répétition du câblage d'une colonne dans les colonnes successives.

Ce procédé peut être mis en oeuvre très facilement en utilisant les outils de conception automatique de circuit déjà largement utilisés pour la conception des circuits intégrés.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Structure de circuits intégrés pour la réalisation d'ensembles logiques traitant des mots de n bits constitués de plusieurs unités fonctionnelles à n étages, caractérisée en ce que:

chaque unité fonctionnelle de l'ensemble à réaliser, est constituée de n cellules complexes de forme rectangulaire ayant toutes les mêmes dimensions X et Y, le long des axes de coordonnées x et y, les cellules étant disposées de façon qu'elles constituent une unité de dimension n X et Y, les cellules de types différents utilisées pour réaliser les différentes unités fonctionnelles ayant toutes la même dimension X, la dimension Y pouvant varier suivant le type de cellule,

les unités fonctionnelles de l'ensemble sont disposées les unes au-dessous des autres de façon que les cellules complexes définissent des colonnes de largeur X, chaque colonne traitant les bits de même ordre.

2. Structure de circuits intégrés selon la revendication 1 caractérisée en ce que, à l'intérieur des différentes cellules complexes les câblages entre composants sont réalisés au premier niveau de métallurgie.

3. Structure selon la revendication 1 ou 2 caractérisée en ce que les lignes de commande de chaque unité fonctionnelle sont communes à toute l'unité et sont pratiquement parallèles entre elles à l'axe x.

4. Structure selon l'une quelconque des revendications précédentes caractérisée en ce que les lignes d'alimentation nécessaires au fonctionnement des cellules sont réalisées à un second niveau de métallique et sont communes à deux cellules consécutives.

5. Structure selon la revendication 4 caractérisée en ce que les éléments de deux cellules consécutives partageant les mêmes lignes d'alimentation sont disposées de façon symétrique par rapport à un axe constitué par le côté commun des cellules consécutives parallèle à l'axe y, les lignes d'alimentation étant situées au voisinage de cet axe et parallèles à celui-ci.

6. Structure selon l'une quelconque des revendications précédentes caractérisée en ce que chaque entrée ou sortie d'une cellule complexe a plusieurs points d'accès.

7. Structure selon la revendication 5 ou 6 caractérisée en ce que le câblage des unités fonctionnelles entre elles est réalisé au second niveau de métallurgie parallèlement aux lignes d'alimentation, le schéma du câblage se faisant dans une colonne et tout out partie du câblage d'une colonne étant réalisée directement par symétrie dans la colonne voisine, tout ou partie de la configuration ainsi obtenue pour deux colonnes consécutives partageant les mêmes lignes d'alimentation étant ensuite transposée aux colonnes suivantes.

8. Structure selon l'une quelconque des revendications précédentes caractérisée en ce qu'un espace est ménagé entre les unités fonctionnelles placées les unes au-dessous des autres, pour permettre d'y placer des lignes de connexion, les lignes de connexion se trouvant dans ces espaces, parallèles à la dimension Y des cellules étant faites au premier niveau de métallurgie.

9. Procédé d'obtention de la structure selon l'une quelconque des revendications précédentes caractérisé en ce qu'il comprend les étapes suivantes:

création d'un catalogue de cellules complexes de types différents, ces cellules ayant toutes une largeur normalisée X et des longueurs Y différentes suivant le type de cellules,
réalisation d'unités fonctionnelles en associant n cellules du même type parallèlement à un axe x, n étant le nombre de bits des mots traités par l'ensemble logique à réaliser,
disposition des unités fonctionnelles les unes au-dessous des autres, les cellules complexes définissant des colonnes parallèles à un axe y perpendiculaire à l'axe x, chaque colonne correspondant à une bit d'ordre donné,
mise en place d'un schéma de câblage dans une colonne et transposition de ce schéma de câblage dans les autres colonnes.

## Patentansprüche

1. Integrierte Schaltungsstruktur zum Herstellen von logischen, n-Bitwörter verarbeitenden Anordnungen, die aus mehreren Funktionseinheiten mit n Stufen bestehen, dadurch gekennzeichnet, daß

jede Funktionseinheit der herzustellenden Anordnung aus n komplexen, rechteckigen Zellen besteht, die alle die gleichen Größen X und Y entlang den x- und y-Koordinatenachsen aufweisen, wobei die Zellen so angeordnet sind, daß sie eine Einheit der Größe n X und Y bilden, und die zum Herstellen der verschiedenen Funktionseinheiten verwendeten verschiedenartigen Zellen alle die gleiche Größe X aufweisen, die Größe Y dagegen je nach der Zellenart veränderlich ist,
die Funktionseinheiten der Anordnung untereinander gestapelt sind, so daß die komplexen Zellen Spalten der Breite X definieren, wobei jede Spalte gleichwertige Bits verarbeitet.

2. Integrierte Schaltungsstruktur nach Anspruch 1, dadurch gekennzeichnet, daß die Verdrahtungen innerhalb der verschiedenen komplexen Zellen auf der ersten Metallisierungsebene hergestellt sind.

3. Struktur nach Anspruch 1 oder 2, dadurch gekennzeichnet, daß die Steuerleitungen einer jeden Funktionseinheit gemeinsam sind und praktisch parallel zueinander und zu der x-Achse verlaufen.

4. Struktur nach einem der vorhergehenden Ansprüche, dadurch gekennzeichnet, daß die zum Betrieb der Zellen erforderlichen Stromversorgungsleitungen auf einer zweiten Metallisierungsebene hergestellt sind und zwei aufeinanderfolgenden Zellen gemeinsam angehören.

5. Struktur nach Anspruch 4, dadurch gekennzeichnet, daß die Elemente in zwei aufeinanderfolgenden und die gleichen Stromversorgungsleitungen benutzenden Zellen bezüglich einer durch die gemeinsame Seite der aufeinanderfolgenden Zellen gebildeten und zur y-Achse parallelen Achse symmetrisch angeordnet sind, wobei die Versorgungsleitungen in der Nähe dieser Achse und parallel dazu angeordnet sind.

6. Struktur nach einem der vorhergehenden Ansprüche, dadurch gekennzeichnet, daß jeder Eingang oder jeder Ausgang einer komplexen Zelle mehrere Zugangspunkte aufweist.

7. Struktur nach Anspruch 5 oder 6, dadurch gekennzeichnet, daß die Verdrahtung der Funktionseinheiten untereinander auf der zweiten Metallisierungsebene und parallel zu den Versorgungsleitungen hergestellt ist, wobei das Verdrahtungsschema in einer Spalte angelegt ist und die ganze oder teilweise Verdrahtung einer Spalte direkt durch Symmetrieübertragung in die benachbarte Spalte hergestellt wird, und wobei das ganze oder teilweise Muster, das durch zwei aufeinanderfolgende und die gleichen Versorgungsleitungen teilenden Spalten erhalten wird, darauf in die folgenden Spalten transponiert wird.

8. Struktur nach einem der vorhergehenden Ansprüche, dadurch gekennzeichnet, daß ein Zwischenraum zwischen den untereinander gestapelten Funktionseinheiten vorgesehen ist, der dazu dient, die Verbindungsleitungen aufzunehmen, wobei diese Verbindungsleitungen, die in diesen Zwischenräumen parallel zu der Größe Y der Zellen liegen, auf der ersten Metallisierungsebene hergestellt sind.

9. Verfahren zum Herstellen einer Struktur nach einem der vorhergehenden Ansprüche, dadurch gekennzeichnet, daß es folgende Verfahrensschritte einschließt:

Erstellen eines Katalogs verschiedenartiger komplexer Zellen, wobei diese Zellen alle eine gleiche Standardbreite X, dagegen je nach Zellenart verschiedene Längen Y aufweisen,
Herstellung von Funktionseinheiten, indem n gleichartige Zellen einer x-Achse parallel zugeordnet werden, wobei n die Anzahl der Bits der Wörter darstellt, die von der herzustellenden Anordnung verarbeitet werden,
Anordnung der Funktionseinheiten untereinander, wobei die komplexen Zellen Spalten parallel zu einer y-Achse und senkrecht zu einer x-Achse bilden, und jede Spalte einem Bit einer bestimmten Wertordnung entspricht,

Ausführung eines Verdrahtungsschemas in einer Spalte und Transponieren dieses Verdrahtungsschemas in die anderen Spalten.

## Claims

1. An integrated circuit structure for implementing logic assemblies that process n-bit words and are composed of several n-stage functional units, characterized in that:

each functional unit of the assembly to be implemented consists of n complex cells of rectangular shape, all being of the same dimension X and Y, along the x and y axes, the cells being arranged so as to form a unit of dimension n X and Y, the different types of cells used for implementing the different functional units all being of the same dimension X, while dimension Y can vary depending on the type of cell,

the functional units of the assembly are stacked, one under the other, so that the complex cells define columns of width X, each column processing the bits of the same order.

2. An integrated circuit structure according to claim 1, characterized in that within the different complex cells the components are wired together at the first metallization level.

3. An integrated circuit structure according to claim 1 or 2, characterized in that the control lines are shared in common by each functional unit and are substantially parallel to each other and to the x axis.

4. An integrated circuit structure according to any one of the preceding claims, characterized in that the power supply lines required for cell operation are located at the second metallization level and are common to two consecutive cells.

5. An integrated circuit structure according to claim 4 characterized in that the elements of two consecutive cells sharing the same power supply lines are symmetrically arranged with respect to an axis formed by the common side of the consecutive cells parallel to the x axis, the power supply lines being located in the vicinity of, and parallel to this axis.

6. An integrated circuit structure according to any one of the preceding claims, characterized in that each input and output of a complex cell is provided with several access points.

7. An integrated circuit structure according to claim 5 or 6, characterized in that the functional units are wired to each other at the second metallization level in parallel to the power supply lines, the wiring scheme being implemented in one column and all or part of the wiring of a column being directly symmetrically implemented in the adjacent column, all or part of the configuration thus obtained for two consecutive columns sharing the same power supply lines being then transposed to the following columns.

8. An integrated circuit structure according to any one of the preceding claims, characterized in that a space is provided between the functional units stacked, one under the other, in order to arrange therein connection lines, the connection lines, located in these spaces in parallel with dimension Y of the cells, being formed at the first metallization level.

9. A method for implementing the structure according to any one of the preceding claims, characterized in that it includes the steps of:

creating a catalogue of complex cells of different types, all of the cells having a standard width X and different lengths Y depending on the type of the cells, implementing the functional units by associating n cells of the same type in parallel with an x axis, n being the number of bits of the words processed by the logic assembly to be achieved.

stacking the functional units, one under the other, the complex cells defining columns that are parallel to an y axis and perpendicular to the x axis, each column corresponding to a bit of a given order,

implementing a wiring scheme in a column and transposing this wiring scheme to the other columns.

FIG. 1

FIG 2

0011737

**0011737**

FIG.4A

CONTACT BASE
CONT.EMETTEUR
CONTACT COLLECTEUR
ISOLATION
SOUS COLLECTEUR

FIG.4B

BASE EMETTEUR
COLLECTEUR

FIG.5

BIT 0 & 1   2 & 3   4 & 5   6 & 7

COL.0   COL.1   COL.2   COL.3   COL.4   COL.5   COL.6   COL.7

LIGNES CONTROLES

CONN. 26

LIGNES CONTROLES

LIGNES CONTROLES

LIGNES CONTROLES

LIGNES CONTROLES

20   22   23   24

2EME CANAL   3EME   4EME CANAL   5EME   6EME CANAL   7EME   8EME CANAL

24   1ER CANAL DE CONNEXION

MASSE
+V
VR

FIG. 6

0011737